(19) Europäisches Patentamt
European Patent Office
Office européen des brevets

(11) Veröffentlichungsnummer: **0 157 374**
**A2**

# (12) EUROPÄISCHE PATENTANMELDUNG

(21) Anmeldenummer: **85103766.3**

(22) Anmeldetag: **28.03.85**

(51) Int. Cl.⁴: **G 03 C 1/68**, G 03 F 7/02, H 05 K 3/34

(30) Priorität: **06.04.84 DE 3412992**

(43) Veröffentlichungstag der Anmeldung: **09.10.85 Patentblatt 85/41**

(84) Benannte Vertragsstaaten: **AT BE CH DE FR GB IT LI NL SE**

(71) Anmelder: **HOECHST AKTIENGESELLSCHAFT, Postfach 80 03 20, D-6230 Frankfurt am Main 80 (DE)**

(72) Erfinder: **Geissler, Ulrich, Dr. Dipl.-Ing., Ruprechtstrasse 22, D-6000 Franfurt/Main (DE)**
Erfinder: **Lampas, Heide, Neudorfgasse 11, D-6203 Hochheim/Main (DE)**

(54) **Durch Strahlung polymerisierbares Gemisch und Verfahren zum Aufbringen von Markierungen auf eine Lötstopresistschicht.**

(57) Durch Strahlung polymerisierbares Gemisch und Verfahren zum Aufbringen von Markierungen auf eine Lötstopresistschicht.

Es wird ein photopolymerisierbares Gemisch beschrieben, das

a) eine radikalisch polymerisierbare Verbindung
b) ein polymeres Bindemittel
c) einen Photopolymerisationsinitiator und
d) eine mit dem Bindemittel (b), mit dem Polymerisationsprodukt von (a) oder mit sich selbst thermisch vernetzbare Verbindung und
e) ein Pigment

enthält. Das Gemisch dient zum Aufbringen von Kennzeichnungen auf gedruckte Schaltungen und wird bevorzugt nach dem Trockenresistverfahren auf die Lötstopresistschicht aufgebracht, belichtet und dann allein oder zusammen mit dieser entwickelt.

EP 0 157 374 A2

H O E C H S T   A K T I E N G E S E L L S C H A F T
KALLE Niederlassung der Hoechst AG



Durch Strahlung polymerisierbares Gemisch und Verfahren zum Aufbringen von Markierungen auf eine Lötstopresistschicht

Die Erfindung betrifft ein photopolymerisierbares Gemisch, das sich, insbesondere in Form einer Trockenresistschicht, auf die Oberfläche einer gedruckten Schaltung, besonders auf eine Lötstopresistschicht, aufbringen und zu sichtbaren Markierungen verarbeiten läßt.

Auf die Bestückungsseite von gedruckten Schaltungen werden häufig Markierungen oder Kennzeichnungsmerkmale aufgebracht, die als Hilfe beim Bestücken mit Bauteilen dienen. Die Markierungen werden gewöhnlich auf den Lötstoplack aufgebracht, mit dem die Leiterplatte unter Aussparung der Lötaugen überzogen ist. Man verwendet für diesen Zweck im wesentlichen pigmentierte Kennzeichnungslacke, die im Siebdruckverfahren aufgebracht werden.

Der Kennzeichnungslack muß eine gute Haftfestigkeit auf der Unterlage, insbesondere auf dem Lötstoplack haben. Die besten Ergebnisse werden mit Zweikomponentenlacken erzielt. Die Verarbeitungs- oder Topfzeit eines fertigen Zweikomponentenlacks beträgt im allgemeinen nicht mehr als 6 bis 8 Stunden; er kann also nur innerhalb dieses Zeitraums verarbeitet werden. Danach geliert die Mischung und wird fest. Man hat auch versucht, Kennzeichnungslacke auf Basis von Druckfarben einzusetzen, die durch UV-Licht

härtbar sind. Mit derartigen Lacken hat man aber bisher nicht die gewünschte Haftfestigkeit erreicht. Wenn diese Lacke auf einen vollständig polymerisierten Lötstopresist mit hohem Oberflächenglanz aufgedruckt werden, ist die Verankerungsmöglichkeit reduziert.

Auch die Resistenz der UV-gehärteten Kennzeichnungen unter den Bedingungen nachfolgender Verarbeitungsschritte, z. B. beim Löten und der daran anschließenden Reinigung mit aggressiven Chemikalien und Reinigungsmitteln unter Ultraschalleinwirkung, ist häufig unzureichend. Ein weiterer Nachteil ist das Absetzen des Pigments bei der Lagerung. Auch ist die Erstellung einer Siebdruckschablone allein für die Kennzeichnung in vielen Fällen mit geringer Stückzahl zu aufwendig.

Andererseits ist es z. B. aus der EP-A 73 444 bekannt, Lötstopmasken nach dem Trockenresistverfahren herzustellen, indem eine photopolymerisierbare Schicht, die polymere Bindemittel, polymerisierbare Verbindungen, Photoinitiatoren und thermisch aktivierbare Vernetzungsmittel enthält, auf die Schaltung laminiert, bildmäßig unter Aussparung der Lötaugen belichtet, entwickelt und schließlich thermisch gehärtet wird. Diese Schichten enthalten gewöhnlich einen Farbstoff, der die entwickelte Lötstopmaske visuell erkennbar macht. Auch kann man Farbstoffe zusetzen, die beim Belichten ausbleichen oder ihren Farbton verändern, um die belichteten von den unbelichteten Stellen unterscheiden zu können. Hierbei muß man jedoch darauf achten, daß die Lichtempfindlichkeit der photopolymerisierbaren Schicht nicht beeinträchtigt wird. Man verwendet also Farbstoffe, die möglichst wenig im kurzwelligen Spektralbereich absorbieren, und setzt sie nur in relativ geringen Konzentrationen zu.

Aufgabe der Erfindung war es, ein Verfahren zum Aufbringen von Markierungen auf gedruckte Schaltungen vorzuschlagen, womit es möglich ist, auf die Oberfläche einer gedruckten Schaltung, d. h. auf die Lötstopmaske, fest haftende Markierungen bzw. Kennzeichnungsmerkmale ohne Erstellung einer Druckschablone aufzubringen, die gegenüber den Bedingungen und Behandlungsoperationen nachfolgender Bearbeitungsschritte, wie Löten und Reinigen, resistent sind.

Erfindungsgemäß wird ein Verfahren zum Aufbringen sichtbarer Markierungen auf eine belichtete Lötstopresistschicht vorgeschlagen. Das erfindungsgemäße Verfahren ist dadurch gekennzeichnet, daß man eine feste thermoplastische photopolymerisierbare Schicht, die ein dispergiertes feinteiliges, zur Farbe der Lötstopresistschicht kontrastierendes Pigment enthält und sich auf einem transparenten flexiblen temporären Schichtträger befindet, unter Druck auf die belichtete und ggf. entwickelte Lötstopresistschicht laminiert, unter einem Negativ der Markierungszeichen belichtet und nach dem Abziehen des temporären Schichtträgers die unbelichteten Bereiche der photopolymerisierbaren Schicht mit einem Entwickler auswäscht.

H O E C H S T   A K T I E N G E S E L L S C H A F T
KALLE Niederlassung der Hoechst AG



Erfindungsgemäß wird ferner ein durch Strahlung polymerisierbares Gemisch vorgeschlagen, das als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein polymeres Bindemittel,

c) einen durch Strahlung aktivierbaren freie Radikale bildenden Polymerisationsinitiator und

d) eine mit dem polymeren Bindemittel (b), mit dem Polymerisationsprodukt der Verbindung (a) und bzw. oder mit sich selbst thermisch vernetzbare Verbindung

enthält.

Das erfindungsgemäße Gemisch ist dadurch gekennzeichnet, daß es ferner e) ein in dem Gemisch dispergierbares feinteiliges Pigment enthält.

Die Komponente d) des Gemischs kann fortfallen, wenn das Bindemittel vernetzende Gruppen enthält, durch die es mit sich selbst oder mit dem Polymerisationsprodukt der ungesättigten Verbindung in der Wärme zu vernetzen vermag.

HOECHST AKTIENGESELLSCHAFT
KALLE Niederlassung der Hoechst AG



Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen-, und Elektronenstrahlung. Auch Laserstrahlung im sichtbaren und UV-Bereich kann verwendet werden. Bevorzugt wird kurzwelliges sichtbares und nahes UV-Licht.

Als polymerisierbare Verbindungen werden im allgemeinen Ester der Acryl- oder Methacrylsäure mit mehrwertigen, vorzugsweise primären, Alkoholen verwendet. Der Alkohol sollte 2 bis etwa 4 Hydroxygruppen enthalten, da durch mehrfach ungesättigte Verbindungen die erwünschte Vernetzungswirkung erreicht wird. In untergeordneter Menge können auch Ester von einwertigen oder höherwertigen Alkoholen im Gemisch enthalten sein. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1000, Neopentylglykol, Trimethylolethan und -propan, Pentaerythrit und oxyethylierte Bisphenol-A-Derivate. Es sind ferner die niedermolekularen, Urethangruppen enthaltenden Bisacrylate und Bismethacrylate geeignet, die durch Umsetzen von 2 mol Hydroxyalkylacrylat oder -methacrylat mit 1 mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Ähnlich geeignete Monomere sind in der EP-A 5750 und der EP-A 73 444 beschrieben.

Es können auch Gemische unterschiedlicher Monomerer verwendet werden. Zum Beispiel ist es möglich, Monomere der oben angegebenen Art mit höhermolekularen, Urethangruppen enthaltenden Monomeren der allgemeinen Formel

$$\left\{[(Ak\text{-}O)_m\text{-}CONH\text{-}Q\text{-}NHCOO]_n\ \begin{array}{c} CH \\ | \\ CH_2 \\ | \\ O \\ | \\ CO \\ | \\ CR \\ \| \\ CH_2 \end{array} \text{-}CH_2\text{-}X\text{-}CH_2\text{-} \begin{array}{c} CH \\ | \\ CH_2 \\ | \\ O \\ | \\ CO \\ | \\ CR \\ \| \\ CH_2 \end{array} \text{-}OCONH\text{-}Q\text{-}NHCOO\right\}_o$$

zu kombinieren, wobei

Q ein zweiwertiger ein- oder zweikerniger aromatischer Rest, der unsubstituiert oder durch niedere Alkylgruppen substituiert ist und der als Bindeglied eine niedere Alkylengruppe enthalten kann,

X eine der Gruppen
$-O-Ph-X'-Ph-O-$ und
$-OOC-(CH_2)_y-COO-$,
wobei Ph eine gegebenenfalls substituierte Phenylengruppe, X' eine Alkylengruppe mit 1 - 4 Kohlenstoffatomen und y eine Zahl von 2 bis 12 ist,

R ein Wasserstoffatom oder eine Methylgruppe,

Ak ein Alkylenrest mit 2-4 Kohlenstoffatomen,
m eine Zahl von 4 bis 50,
n eine Zahl von 1 bis 6 und
o eine Zahl von 4 bis 20 ist.

Die Herstellung dieser Polyetheresterurethane erfolgt in bekannter Weise durch Umsetzen von oligomeren Diisocyanaten der Formel

$$OCN\text{-}Q\text{-}[NHCOO\text{-}(AkO)_m CONH\text{-}Q\text{-}]_n NCO$$

mit Bis-acrylsäureester-diolen der Formel

$$(H_2C{=}\overset{\overset{R}{|}}{C}\text{-}\overset{\overset{O}{\|}}{C}\text{-}O\text{-}CH_2\text{-}\underset{\underset{OH}{|}}{CH}\text{-}CH_2\text{-})_2X$$

Die Herstellung und Verwendung dieser Verbindungen ist in der EP-A 48 913 beschrieben.

Diese Polyurethane haben im allgemeinen reduzierte spezifische Viskositäten (RSV), gemessen an 1%igen Lösungen in Dimethylformamid bei 25°C, von etwa 0,15 bis 1,4 dl/g.

Bevorzugt werden Produkte mit RSV-Werten im Bereich von 0,2 bis 0,9 dl/g.

Bevorzugte mittlere Werte von m liegen bei 8-20, von n bei 2-4, von o bei 5-12 und von y bei 2-6.

X' ist eine Alkylengruppe, in der die freien Valenzen bevorzugt an einem C-Atom stehen. Bevorzugte Gruppen sind Methylen-, 1,1-Ethylen- und 2,2-Propylengruppen. R ist vorzugsweise eine Methylgruppe.

Die Gesamtmenge an polymerisierbaren Verbindungen liegt im allgemeinen zwischen 10 und 50, vorzugsweise bei 15 bis 45, Gew.-%, bezogen auf die nichtflüchtigen Anteile des Gemischs. Von dieser Menge können 2 bis 20, bevorzugt 5 bis 10 Gew.-%, auf die gleiche Basis bezogen, aus Polyurethanen der oben angegebenen allgemeinen Formel bestehen.

Die erfindungsgemäßen Gemische enthalten ferner ein polymeres, bevorzugt gesättigtes Bindemittel. Vorzugsweise werden wasserunlösliche, in wäßrig-alkalischen Lösungen lösliche oder mindestens quellbare Bindemittel verwendet. Als alkalilöslichmachende Gruppen können die Bindemittel Phosphonsäure-, Sulfonsäure-, Sulfonamid-, Sulfonylurethan-, Carbonsäureanhydrid- und bevorzugt Carboxylgruppen enthalten. Bevorzugte Bindemittel sind Mischpolymerisate aus Methacrylsäure und Alkylmethacrylaten und gegebenenfalls noch Styrol oder anderen Comonomeren, wie sie in den DE-A 20 64 080 und 23 63 806 beschrieben sind. Besonders bevorzugt werden Bindemittel, die seitenständig thermisch vernetzbare Gruppen enthalten, z. B. Gruppen der Formel $-CH_2OR$, worin R ein Wasserstoffatom

oder eine niedere Alkyl- oder Acylgruppe ist. Die Gruppen können an Sauerstoff- oder Stickstoffatomen stehen, z. B. in Einheiten von Acryl- bzw. Methacrylamid oder -säureestern. Derartige Bindemittel sind in der älteren deutschen Patentanmeldung P 33 29 443.7 beschrieben, z. B. Terpolymerisate von Methacrylsäure, Alkylmethacrylaten und N-Alkoxymethyl-methacrylamiden. Die Bindemittel werden in einer Menge von 40 bis 80, vorzugsweise 50 bis 70 Gew.-%, der nichtflüchtigen Bestandteile des Gemischs verwendet.

Als Photoinitiatoren in dem erfindungsgemäßen Gemisch können eine Vielzahl von Substanzen Verwendung finden. Beispiele sind Benzoin und seine Derivate, Mehrkernchinone, Trichlormethyl-s-triazine, Trihalogenmethylgruppen enthaltende Carbonylmethylenheterocyclen, z. B. 2-(p-Trichlormethyl-benzoylmethylen)-3-ethyl-benzthiazolin, Acridinderivate, z. B. 9-Phenyl-acridin, 9-p-Methoxy-phenyl-acridin, 9-Acetylamino-acridin, Benz(a)acridin; Phenazinderivate, z. B. 9,10-Dimethylbenz(a)phenazin, 9-Methyl-benz(a) phenazin, 10-Methoxybenz(a)-phenazin, Chinoxalinderivate, z. B. 6,4',4"-Trimethoxy-2,3-diphenylchinoxalin, 4',4"Dimethoxy-2,3-diphenyl-5-azachinoxalin oder Chinazolinderivate. Die Acridin-, Phenazin- und Chinoxalinderivate werden bevorzugt. Die Photoinitiatoren werden allgemein in einer Menge von 0,01 bis 10, vorzugsweise von 0,05 bis 2 Gew.-% verwendet.

Die erfindungsgemäßen Gemische enthalten außerdem etwa 1 - 30 Gew.-% eines anorganischen oder organischen Pigments. Der Pigmentanteil ist abhängig von der Art des

HOECHST AKTIENGESELLSCHAFT
KALLE Niederlassung der Hoechst AG



Pigments und der Schichtdicke. Er liegt bevorzugt zwischen 5 und 15 Gew.-%, besonders bei einer Dicke der Schicht um 25/um. Unter den anorganischen Pigmenten sind Oxid- und Hydroxid-Pigmente (z.B. Titandioxid, Zinkoxid), Sulfidpigmente (z.B. Zinksulfid, Cadmiumpigmente), Chromatpigmente (z.B. Chromgelb, Chromorange, Zinkgelb) zu nennen. Beispiele für organische Pigmente sind Mono- und Bisazopigmente, schwerlösliche Salze von anionischen Azofarbstoffen, schwerlösliche Salze von kationischen Farbstoffen, Kupferphthalocyanine und sonstige Metallkomplexpigmente, Pigmente aus der Gruppe der Carbonyl-Farbstoffe, Azin- und Dioxazinpigmente.

Vorzugsweise enthalten die Gemische zusätzlich geringe Mengen eines Farbstoffs, der bei Bestrahlung seine Farbe ändert, wodurch unmittelbar nach der Belichtung bereits das Bild in der Schicht zu erkennen ist.

Als Farbstoffe, die bei Belichtung einen Farbumschlag zeigen, sind z. B. Triphenylmethanfarbstoffe und bestimmte Azofarbstoffe, wie sie in der DE-A 28 07 933 (= US-A 4 241 166) beschrieben sind, geeignet.

Als Verbindungen, die mit dem Bindemittel, dem Polymerisationsprodukt der ethylenisch ungesättigten Verbindung und/oder mit sich selbst thermisch vernetzbar sind, sind bevorzugt solche geeignet, die als vernetzende Gruppen Epoxygruppen oder Gruppen der Formel $-CH_2-O-R$ enthalten, worin R ein Wasserstoffatom, eine niedere Alkyl-, Acyl- oder Hydroxyalkylgruppe ist und in denen die

Gruppen $-CH_2OR$ an einem Stickstoffatom eines offenkettigen oder cyclischen Säureamids oder an einem aromatischen Kohlenstoffatom einer zur Kondensation mit Formaldehyd befähigten Verbindung stehen. Die organischen Reste R enthalten im allgemeinen 1 bis 4, bevorzugt 1 bis 2 Kohlenstoffatome.

Bevorzugt werden Derivate cyclischer Säureamide, z. B. von Melamin, insbesondere Hexaalkoxymethylmelamin.

Die vernetzenden Verbindungen sind in dem Gemisch gewöhnlich in einer Menge von etwa 0,5 bis 30, vorzugsweise 5 bis 25 Gew.-%, bezogen auf seine nichtflüchtigen Bestandteile, enthalten.

Die erfindungsgemäßen Gemische können außer Monomeren, Bindemitteln, Photoinitiatoren, Vernetzern und Pigmenten noch eine Reihe weiterer üblicher Zusätze enthalten, z.B. Inhibitoren zur Verhinderung der thermischen Polymerisation der Monomeren, Wasserstoffdonatoren, sensitometrische Regler, Flammschutzmittel und Weichmacher.

Das erfindungsgemäße Gemisch findet bevorzugt Anwendung als Kennzeichnungsresist. Dazu kann es in bekannter Weise aus einer Lösung (bzw. Dispersion) oder als vorgefertigte übertragbare Trockenresistfolie auf eine Leiterplatte, die bevorzugt mit einer Lötstopmaske abgedeckt ist, aufgebracht werden. Das Gemisch wird bevorzugt als Trockenresistmaterial verarbeitet. Im allgemeinen wird eine Lösung des Gemischs in einem Lösemittel auf einen geeig-

HOECHST AKTIENGESELLSCHAFT
KALLE Niederlassung der Hoechst AG



neten Schichtträger, z. B. eine Polyesterfolie, aufgebracht und getrocknet. Die Schichtdicke der Resistschicht kann etwa 10 bis 50, vorzugsweise 20 bis 30 μm betragen. Die freie Oberfläche der Schicht wird vorzugsweise mit einer Deckfolie, z. B. aus Polyethylen oder Polypropylen, abgedeckt.

Die Resistrollen bleiben auch nach einer Lagerung von Monaten bei 20°C unverändert und lassen sich problemlos verarbeiten, die Schnittkanten sind völlig frei von zur Verklebung führenden Resistaustritten. Die über 2 Monate bei 40°C im Trockenschrank gelagerten Resistschichten zeigen gegenüber frisch hergestellten Schichten keinen Unterschied bezüglich Laminierbarkeit, Entwickelbarkeit und Lötresistenz.

Die Folien lassen sich mit in der Trockenresisttechnik üblichen Geräten verarbeiten. In einer handelsüblichen Laminiervorrichtung wird die Deckfolie abgezogen und die Kennzeichnungsresistschicht auf eine mit einer Lötstopresistschicht überzogene und durch eine Vorlage belichtete Leiterplatte laminiert. Die Kennzeichnungsresistschicht kann auch auf eine mit einer entwickelten Lötstopmaske bedeckte Leiterplatte laminiert werden. Die so präparierte Platte wird dann durch eine Vorlage belichtet, wobei nur die Schichtteile vom Licht getroffen werden, die die Kennzeichnung bzw. die Markierung bilden sollen.

Entwickelt werden die von der Trägerfolie befreiten Resistschichten in bekannter Weise, entweder Lötstopresistschicht und Kennzeichnungsresistschicht gemeinsam oder nur die Kennzeichnungsresistschicht. Als Entwickler sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösungsmitteln oder Netzmitteln zugesetzt werden können.

Die mit Lötstopmaske und Kennzeichnung versehenen Leiterplatten müssen nun vor dem Lötprozeß einer Temperaturbehandlung unterzogen werden.

Es wird angenommen, daß sich hierbei ein interpenetrierendes Netzwerk ausbildet, das eine gute mechanische, thermische und chemische Resistenz bewirkt. Diese thermische Behandlung erfolgt im allgemeinen zwischen 130°C und 150°C, bei ungefähren Behandlungszeiten von 30 bis 60 Minuten.

Die Leiterplatte kann nach den mit Hilfe des Kennzeichnungsresists aufgebrachten Markierungen und Bauteilekennzeichnungen mit elektronischen Bauelementen bestückt, anschließend mit einem geeigneten handelsüblichen Flußmittel behandelt und dann auf einer handelsüblichen Schwall-Lötmaschine gelötet werden.

Mit Hilfe der Resisttechnik können Markierungen und Bauteilekennzeichnungen schnell und präzise auf Leiterplatten aufgebracht werden. Der Kennzeichnungsresist besitzt eine gute Haftung insbesondere auf Lötstopmasken, er ist bei den üblichen Löttemperaturen beständig und zeigt auch eine ausreichende Resistenz gegenüber Chemikalien, Reinigungsmitteln und Ultraschallbehandlung. Überraschenderweise wird die Kennzeichnungsresistschicht trotz des relativ hohen Anteils an Pigment und der dadurch hervorgerufenen hohen optischen Dichte innerhalb praktikabler Belichtungszeiten so weit durchgehärtet, daß auch kleine Zeichen beim Entwickeln nicht von der Lötstopresistschicht abgewaschen werden.

Die folgenden Beispiele erläutern einzelne Ausführungsformen des erfindungsgemäßen Gemischs. Wenn nichts anderes angegeben ist, sind Prozentzahlen und Mengenverhältnisse in Gewichtseinheiten zu verstehen. Die Mengen sind in den Rezepturen in Gewichtsteilen (Gt) angegeben.

Beispiel 1

In einer Korundmühle wurden 3 Gt Titandioxid Kronos RNCX der Firma Kronos Titan GmbH mit 14 Gt einer 30 %igen Lösung eines Styrol-Hexylmethacrylat-Methacrylsäure-Copolymeren (10:60:30 Gew.-%) in Butanon innig vermischt.

Anschließend wurden unter Rühren folgende Bestandteile zu dieser Dispersion gegeben:

29,33 Gt der oben erwähnten 30 %igen Terpolymerenlösung,

HOECHST AKTIENGESELLSCHAFT
KALLE Niederlassung der Hoechst AG



| | | |
|---|---|---|
| 1,6 | Gt | eines elastomeren Reaktionsprodukts aus Glycidylmethacrylat, Adipinsäure und einem oligomeren Diisocyanat, das durch Umsetzen von Tolylendiisocyanat mit einem Poly-butan-1,4-diol erhalten worden war (vgl. DE-A 30 36 694), |
| 7,4 | Gt | Polyethylenglykol-400-dimethacrylat, |
| 0,01 | Gt | 9-Phenylacridin, |
| 1,0 | Gt | Hexamethoxymethyl-melamin, |
| 0,0075 | Gt | eines blauen Azofarbstoffs, erhalten durch Kuppeln von 2,4-Dinitro-6-chlor-benzol-diazoniumsalz mit 2-Methoxy-5-acetylamino-N,N-diethylanilin und |
| 11 | Gt | Ethanol. |

Mit der angegebenen Mischung wurde eine biaxial verstreckte und thermofixierte Polyethylenterephthalatfolie der Stärke 25 µm kontinuierlich beschichtet. Nach Durchlaufen einer Trockenzone hatte die Resistschicht eine Dicke von 25 µm und wurde mit einer Polypropylenfolie abgedeckt.

Die Trockenresistschicht wurde nach Abziehen der Polypropylenfolie mit einer handelsüblichen Laminiervorrichtung bei 115°C (a) auf eine mit einer photopolymerisierbaren Lötstopresistschicht überzogene und durch eine Vorlage belichtete Leiterplatte laminiert.

Die photopolymerisierbare Lötstopresistschicht hatte die folgende Zusammensetzung:

13 Gt eines Terpolymeren aus n-Hexylmethacrylat, Methacrylsäure und Styrol (60:30:10) mit einem mittleren Molgewicht von ca. 35000 und der Säurezahl 195,
6,4 Gt Polyethylenglykol-400-dimethacrylat,
1,6 Gt des oben angegebenen polymerisierbaren Elastomeren,
0,2 Gt 9-Phenylacridin,
0,41 Gt Hexamethoxymethyl-melamin,
0,01 Gt des oben angegebenen blauen Azofarbstoffs und
0,03 Gt 1,4-Bis-(4-tert.-butoxy-phenylamino)-5,8-dihydroxy-anthrachinon.

Bei einer zweiten Probe (b) wurde die Resistschicht auf eine mit Lötstopresist beschichtete, belichtete und entwickelte Leiterplatte laminiert.

Die Platten wurden 12 Sekunden mit einem handelsüblichen Belichtungsgerät (5 kW-Metallhalogenidlampe) belichtet. Als Vorlage diente neben einem Kennzeichnungsdruck-Negativ ein 13-stufiger Halbtonstufenkeil mit Dichteinkrementen von 0,15. Anschließend wurden die Platten mit 1 %iger Sodalösung in einem Durchlaufentwicklungsgerät entwickelt. Es wurden drei vollvernetzte Keilstufen erhalten. Bei einer Entwicklertemperatur von 30°C betrug die Entwicklungszeit für den Kennzeichnungsresist (b) 60 Sekunden, die gemeinsame Entwicklung von Lötstopresist und Kennzeichnungsresist (a) erforderte 220 Sekunden.

Die so präparierten Leiterplatten wurden dann in einem Trockenschrank 60 Minuten bei 150°C gehärtet und anschließend auf einer Schwallötanlage gelötet. Die gelöteten Platten zeigten keinerlei Abplatzungen des Kennzeichnungsresists. Auch feinste Buchstaben oder Zahlen konnten nicht mit einem Klebeband abgezogen werden.

Beispiel 2

Es wurde eine Beschichtungslösung wie in Beispiel 1 bereitet, die anstelle der dort eingesetzten Menge Polyethylenglykol-400-dimethacrylat 7,4 Gt einer Mischung dieses Monomeren mit dem Reaktionsprodukt aus 1 mol Triethylenglykol, 2 mol 2,2,4-Trimethylhexamethylendiisocyanat und 2 mol Hydroxyethylmethacrylat im Gewichtsverhältnis 4,4 : 3 enthielt.

Die Mischung wurde auf eine Polyethylenterephthalatfolie so aufgeschleudert, daß nach dem Trocknen bei 100°C ein Schichtgewicht von 28 g/m$^2$ erhalten wurde.

Der Kennzeichnungsresist wurde wie im Beispiel 1 weiterverarbeitet.

| | |
|---|---|
| Belichtungszeit: | 20 Sekunden |
| Entwicklungszeit (1%ige Sodalösung): | 100 Sekunden |
| Anzahl der vernetzten Keilstufen: | 3 (4) |
| Tempern: | 60 Minuten bei 150°C |

Auch hier waren nach dem Löten keinerlei Abplatzungen des Kennzeichnungsresists zu beobachten.

0157374



Beispiel 3

Es wurden folgende Mischungen hergestellt:

a)
39 Gt eines Terpolymerisats aus 25 Gew.-% N-Butoxymethyl-methacrylamid, 25 Gew.-% Methacrylsäure und 50 Gew.-% Hexylmethacrylat,
9 Gt Titandioxid wie in Beispiel 1,
9 Gt Hexamethoxymethyl-melamin,
16,2 Gt Polyethylenglykol-400-dimethacrylat,
0,0225 Gt des in Beispiel 1 erwähnten blauen Farbstoffs und
0,03 Gt 9-Phenylacridin in
100 Gt Butanon und
20 Gt Ethanol

b)
39 Gt des oben angegebenen Terpolymerisats,
9 Gt Titandioxid (wie oben),
3 Gt Hexamethoxymethyl-melamin,
22,2 Gt Polyethylenglykol-400-dimethacrylat,
0,0225 Gt des blauen Farbstoffs aus Beispiel 1 und
0,03 Gt 9-Phenylacridin in
100 Gt Butanon und
20 Gt Ethanol

Nach dem Mischen in einer Korundmühle wurden die Beschichtungslösungen jeweils auf eine Polyesterfolie aufgeschleudert und getrocknet (Schichtgewicht 30 $g/m^2$). Die weitere Verarbeitung erfolgte wie in Beispiel 1a, jedoch wurde auf eine belichtete Lötstopresistschicht der folgenden Zusammensetzung laminiert:

| | | |
|---|---|---|
| 52 | Gt | eines Terpolymerisats aus N-Butoxymethyl-methacrylamid, Methacrylsäure und Hexylmethacrylat (25:25:50), |
| 17,6 | Gt | Polyethylenglykol-400-dimethacrylat, |
| 4 | Gt | Hexamethoxymethyl-melamin, |
| 0,8 | Gt | 9-Phenylacridin, |
| 0,04 | Gt | des in Beispiel 1 angegebenen blauen Azofarbstoffs, |
| 0,12 | Gt | 1,4-Bis-(4-tert.-butoxy-phenylamino)-5,8-dihydroxy-anthrachinon. |

Die optimale Belichtungszeit betrug für Schicht (a) 16 Sekunden, für Schicht (b) 12 Sekunden. Die Anzahl der vollvernetzten Keilstufen nach dem Entwickeln betrug jeweils 3 (4). Die Platten wurden anschließend 60 Minuten bei 150°C getempert. Die so aufgebrachte Kennzeichnung haftete ausgezeichnet auf der Lötstopmaske. Auch nach 3-tägiger Einwirkung von Ethanol war keine Ablösung zu beobachten. Die Lötbadbeständigkeit war hervorragend.

Ähnlich gute Ergebnisse wurden erhalten, wenn anstelle des Titandioxids die gleiche Menge Chromgelb verwendet wurde.

Beispiel 4

Eine Lösung aus

| | | |
|---|---|---|
| 39 | Gt | des in Beispiel 1 angegebenen Terpolymerisats, |
| 13 | Gt | eines N-Methoxymethyl-methacrylamid-Hexylmethacrylat-Copolymerisats (1:1), |

| | | |
|---|---|---|
| 8 | Gt | des in Beispiel 1 angegebenen polymerisierbaren Elastomeren, |
| 22 | Gt | Polyethylenglykol-400-dimethacrylat, |
| 12 | Gt | Titandioxid wie in Beispiel 1, |
| 5 | Gt | Hexamethoxymethyl-melamin, |
| 1 | Gt | 9-Phenylacridin, |
| 0,03 | Gt | des blauen Azofarbstoffs aus Beispiel 1 und |
| 210 | Gt | Butanon |

wurde auf eine mit einer belichteten Lötstopresistschicht beschichtete Leiterplatte so aufgeschleudert, daß nach dem Trocknen ein Schichtgewicht von 27 g/m$^2$ erhalten wurde. Die Platte wurde wie in Beispiel 1 (a) weiterverarbeitet, wobei ähnliche Ergebnisse wie dort erhalten wurden.

H O E C H S T   A K T I E N G E S E L L S C H A F T
KALLE Niederlassung der Hoechst AG



## Patentansprüche

1. Durch Strahlung polymerisierbares Gemisch, das als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein polymeres Bindemittel,

c) einen durch Strahlung aktivierbaren freie Radikale bildenden Polymerisationsinitiator und

d) eine mit dem polymeren Bindemittel (b), mit dem Polymerisationsprodukt der Verbindung (a) und bzw. oder mit sich selbst thermisch vernetzbare Verbindung

enthält, dadurch gekennzeichnet, daß das Gemisch ferner

e) ein in dem Gemisch dispergierbares feinteiliges Pigment

enthält.

2. Durch Strahlung polymerisierbares Gemisch nach Anspruch 1, dadurch gekennzeichnet, daß es das Pigment in einer Menge von 1 - 30 Gew.-%, bezogen auf den Gehalt an nichtflüchtigen Bestandteilen, enthält.

3. Durch Strahlung polymerisierbares Gemisch nach Anspruch 1, dadurch gekennzeichnet, daß es ferner einen Farbstoff enthält, der bei Bestrahlung seine Farbe ändert.

4. Durch Strahlung polymerisierbares Gemisch nach Anspruch 1, dadurch gekennzeichnet, daß die thermisch vernetzbare Verbindung (d) eine Verbindung mit mindestens zwei Epoxygruppen oder mindestens zwei Gruppen der Formel $-CH_2-O-R$ ist, wobei R ein Wasserstoffatom, eine niedere Alkyl-, Acyl- oder Hydroxyalkylgruppe ist.

5. Verfahren zum Aufbringen sichtbarer Markierungen auf eine belichtete Lötstopresistschicht, dadurch gekennzeichnet, daß man eine feste thermoplastische photopolymerisierbare Schicht, die ein dispergiertes feinteiliges zur Farbe der Lötstopresistschicht kontrastierendes Pigment enthält und sich auf einem transparenten flexiblen temporären Schichtträger befindet, unter Druck auf die belichtete und ggf. entwickelte Lötstopresistschicht laminiert, unter einem Negativ der Markierungszeichen belichtet und nach dem Abziehen des temporären Schichtträgers die unbelichteten Bereiche der photopolymerisierbaren Schicht mit einem Entwickler auswäscht.

6. Verfahren nach Anspruch 5, dadurch gekennzeichnet, daß man die Lötstopresistschicht und die pigmentierte photopolymerisierbare Schicht so auswählt, daß beide mit dem gleichen Entwickler verarbeitet werden können, daß man die pigmentierte photopolymerisierbare Schicht vor dem Entwickeln der Lötstopresistschicht auf diese laminiert und daß man beide Schichten in einem Arbeitsgang entwickelt.